# EUROPEAN PATENT APPLICATION

(11) **EP 3 170 923 A1**
(43) Date of publication of application: **24.05.2017**
(21) Application number: 16197795.4
(22) Date of filing: 08.11.2016
(51) Int. Cl.: C25D 3/38, C25D 17/00, C25D 17/06

(54) **METHOD OF ELECTROPLATING LOW INTERNAL STRESS COPPER DEPOSITS ON THIN FILM SUBSTRATES TO INHIBIT WARPING**

(30) Priority: 19.11.2015 US 201562257262 P
(71) Applicant: Rohm and Haas Electronic Materials LLC, Marlborough, MA 01752 (US)
(72) Inventor: KAO, Yu Hua, Marlborough, MA 01752 (US); WEI, Lingyun, Marlborough, MA 01752 (US); GOMEZ, Luis, Marlborough, MA 01752 (US); LEFEBVRE, Mark, Marlborough, MA 01752 (US)
(74) Representative: Houghton, Mark Phillip

(57) **Abstract**

Thin film substrates are electroplated with copper from low internal stress, high ductility acid copper electroplating baths. During the copper electroplating process the thin film substrates can warp or bow. To address the problem of warping or bowing during copper electroplating the thin film substrate is held by a securing means which inhibits the thin film substrate from excessive activity.

## Description

### Field of the Invention

The present invention is directed to a method of electroplating low internal stress copper deposits on thin film substrates to inhibit warping of the thin film substrates. More specifically, the present invention is directed to a method of electroplating low internal stress copper deposits on thin film substrates to inhibit warping of the thin film substrates by using a securing means to inhibit excessive activity of the thin film substrate during copper electroplating.

### Background of the Invention

Internal or intrinsic stress of electrodeposited metals is a well known phenomenon caused by imperfections in the electroplated crystal structure. After the electroplating operation such imperfections seek to self correct and this induces a force on the deposit to contract (tensile strength) or expand (compressive stress). This stress and its relief can be problematic. For example, when electroplating is predominantly on one side of a substrate it can lead to curling, bowing and warping of the substrate depending on the flexibility of the substrate and the magnitude of the stress. Stress can lead to poor adhesion of the deposit to the substrate resulting in blistering, peeling or cracking. This is especially the case for difficult to adhere substrates, such as semiconductor wafers or those with relatively smooth surface topography. In general, the magnitude of stress is proportional to deposit thickness thus it can be problematic where thicker deposits are required or indeed may limit the achievable deposit thickness.

Most metals including copper deposited from an acid electroplating process exhibits internal stress. Commercial copper acid electroplating processes utilize various organic additives which beneficially modify the electroplating process and deposit characteristics. It is also known that deposits from such electroplating baths may undergo room temperature self annealing. Transformation of the grain structure during such self annealing concurrently results in a change in the deposit stress, often increasing it. Not only is internal stress problematic in itself but is typically subject to change on aging as the deposit self anneals with time resulting in unpredictability.

The fundamental mechanism of alleviating intrinsic stress in copper electroplating is not well understood. Parameters, such as reducing deposit thickness, lowering current density, i.e., plating speed, substrate type, seed layer or under plate selection, electroplating bath composition, such as anion type, additives, impurities and contaminants are known to affect deposit stress. Such empirical means of reducing stress have been employed though typically are not consistent or compromise the efficiency of the electroplating process.

Recent work directed to developing electroplating baths to address the problem of internal stress has been somewhat successful; however, as the plating industry moves to thinner substrates warping has become an increasing concern. Even many of the improved copper electroplating baths directed to addressing the problems of internal stress have not been able to resolve the warping problem when plating on thin substrate. Accordingly, there is a need for a method of reducing or eliminating the problem of metal plated thin film substrate warping.

### Summary of the Invention

A method of copper electroplating a thin film substrate comprising: providing the thin film substrate; attaching the thin film substrate to a securing means to inhibit substantially all motion of the thin film substrate in relation to the securing means; attaching one or more electrical contacts to the thin film substrate; passing the thin film substrate attached to the securing means and with the one or more electrical contacts through a low stress, high ductility copper electroplating bath wherein the thin film substrate and securing means with the one or more electrical contacts remain substantially in a single plane while passing through the copper electroplating bath; and electroplating low stress, high ductility copper on the thin film substrate with the low stress, high ductility copper electroplating bath.

The method enables the thin film substrate to pass through a low internal stress, high ductility copper electroplating bath such that the thin film substrate does not warp or bow after copper electroplating. The thin film substrate remains substantially flat with the copper deposit plated on it.

### Brief Description of the Drawings

Figures 1A-F are illustrations of copper grain growth for two different copper electroplating arrangements.
Figures 2A-B are illustrations of a copper thin film joined to a plating jig with electrical and non-electrical contacts.
Figures 3A-C are illustrations of a copper thin film with electrical contacts secured to a conveyor and two alternative conveyor designs for securing the copper thin film.
Figures 4A-B are illustrations of copper thin films connected to three electrical connectors on one side or at the top of the film.

### Detailed Description of the Invention

The following abbreviations have the following meanings unless the context clearly indicates otherwise: °C = degrees Celsius; g = grams; mL = milliliter; L = liter; ppm = parts per million = mg/L; A = amperes = Amps; DC = direct current; m = meters; dm = decimeter; mm = millimeter; µm = micrometers; nm = nanometers; Mw = weight average molecular weight; ASD = A/dm²; v = volts; 2.54 cm = 1 inch; lbf = pound-force = 4.44822162 N; N = newtons; psi = pounds per square inch = 0.06805 atmospheres; 1 atmosphere = 1.01325x10⁶ dynes/square centimeter; and RFID = radio frequency identification.

As used throughout this specification, the term "depositing", "plating" and "electroplating" are used interchangeably. The term "lateral" means from the side or sides. The term "axis" refers to an imaginary line about which a body rotates. The term "moiety" means a part or a functional group of a molecule. The moiety " 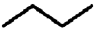 " = -CH₂-CH₂-. Indefinite articles "a" and "an" include both the singular and the plural. The term "ductility" means a solid material's ability to deform under tensile stress. The term "tensile stress" means the maximum stress a material withstands before failing. The term "plane" means a flat surface on which a straight line joining any two points on it lies wholly in it.

All percentages and ratios are by weight unless otherwise indicated. All ranges are inclusive and combinable in any order except where it is clear that such numerical ranges are constrained to add up to 100%.

Thin film substrates of the present invention are secured by a securing means such that the thin film substrates remain in one plane during the electroplating process. The securing means prevents the thin film substrate from any activity or change in planar position throughout the electroplating process. It restrains undesired motion of the thin film substrate while the substrate passes through a plating bath. In contrast, conventional processes for electroplating thin film substrates typically involve passing the thin films through a copper electroplating bath where the thin film substrate is allowed significant activity or motion throughout the electroplating process. Such thin film substrates are typically joined to a conveyor system at one point such that the thin film substrates rotate about the axis where they are joined to the conveyor and readily move from side to side outside a single plane. Such activity often results in a warped thin film substrate. Such warping is often more pronounced after the plated substrates are allowed to age at room temperature. Copper plated on the substrates typically cracks or peels. While not being bound by theory, copper grain growth is different in the two plating processes. When the thin film substrate is secured such that it remains in a single plane during electroplating, more copper grains/nuclei fit in voids between an initial layer of copper nuclei. This is more favorable to inhibit substrate warping. In conventional processes, the substrate has flexibility to move during plating. Once the copper nucleation starts, there is less copper nuclei being able to fit in the voids before the initial copper nuclei evolve/anneal to larger grain size. Therefore the volume contraction during annealing is larger than the volume contraction of thin films plated according to the method of the present invention.

Thin films of the present invention have thickness ranges of 220 µm or less but greater than 0. Preferably the thin films have a thickness range from 50 µm to 150 µm, more preferably from 50 µm to 100 µm. Such thin film substrates are patterned by copper seeds which have thicknesses of a few nanometers. The patterns can be a plurality of asymmetric lines which can vary in width and are orientated in one direction on one side of the substrate. Warping typically occurs along the lines.

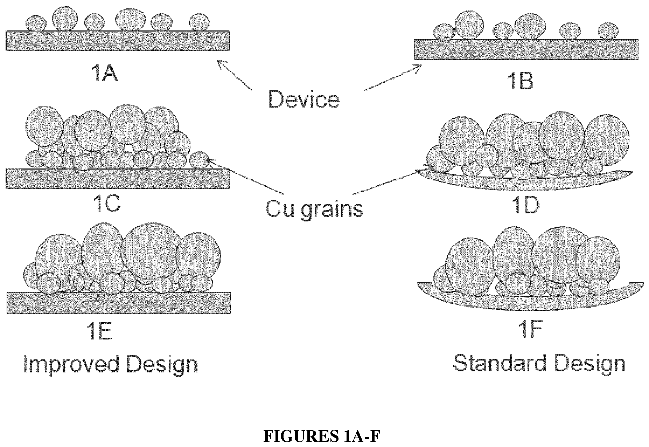

Figures 1A-F compares the two processes. Figures 1A and 1B illustrate the initial plating deposit. Figure 1A is the deposit plated according to the method of the present invention where the thin film substrate is held in one plane during plating by a securing means. In contrast, Figure 1B is the deposit plated on the thin film substrate using a conventional process where the thin film is allowed substantial freedom of movement during plating. Figure 1C illustrates that small copper nuclei or grains are allowed to be deposited within the voids amongst the initial deposit layer due to limited motion of the substrate, while in conventional design shown in Figure 1D the copper nuclei or small grains from the initial copper deposit layer have already started to anneal or grow and therefore the thin film substrate bends in order to accommodate the volume shrinkage. In other words, more copper grains are fitted in the design of the present invention and thus less volume contraction than in the conventional approach. The present invention provides a physical force to counteract the stress caused by the annealing. Figure 1E illustrates the copper grain size of the thin film substrate plated according to the method of the present invention after aging at room temperature. The copper grain size has increased to the point of being equivalent to the grain sizes of the copper of Figure IF using a conventional process; however, no warping is present.

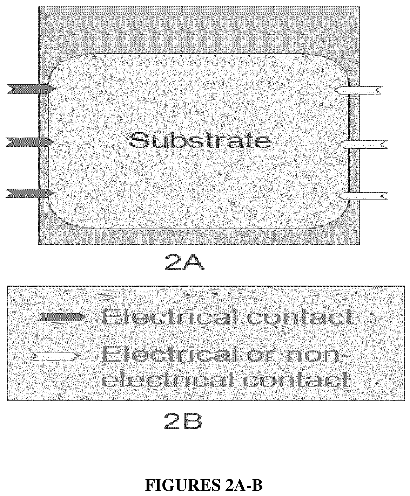

Securing means for thin film substrates can be a plating jig such as shown in Figure 2A where the thin film substrate is joined to the jig by three electrical contacts and three non-electrical contacts. Alternatively, the thin film substrate can be secured by six electrical contacts. The thin film is secured to the plating jig such that it does not move but remains stationary in relation to the jig. The jig is then secured to a conveyor belt such that it remains stationary with respect to its position on the conveyor. The jig can be secured to the conveyor at any one of its points provided it remains stationary to its position on the conveyor. Typically the jig is secured to the conveyor belt at one or more points along its top edge and at one or more points along its bottom edge. Nuts and bolts or clamps or other securing means can be used to join the plating jig to the conveyor belt. The conveyor belt can include a plurality of plating jigs such that a plurality of thin films can be joined to the conveyor at the same time and copper electroplated on the thin films in sequence. The conveyor is activated by a motor which passes the thin films to a tank containing a low internal stress, high ductility copper electroplating bath. The tank includes one or more counter electrodes. The electrodes can be soluble or insoluble electrodes. On entering the plating tank the electrical contacts joined to the thin film are placed under a potential from an electric rail through gliding contacts joined to the electrical contacts at the ends opposite to where they make contact with the thin film. The potential applied to the electrical contacts is from 10 v to 60 v provided by a rectifier. As each thin film substrate passes through the plating tank each remains in the same plane such that they do not move outside the plane during electroplating. The only motion experienced by each thin film is the motion of moving in a continuous plane from the entrance of the plating tank until it passes out of the tank at an opposite end. The thin films do not revolve about an axis or move laterally to the plane in which the thin films pass through the plating tank during the electroplating process. In general, the rate at which the thin films pass through the electroplating tank is from 0.2 m/minute to 5 m/minute. Such speeds have minimal to no impact on warping of the thin films. After the thin films pass out of the plating tank with their copper plated surfaces, they are retrieved at the end of the plating line or plating circuit.

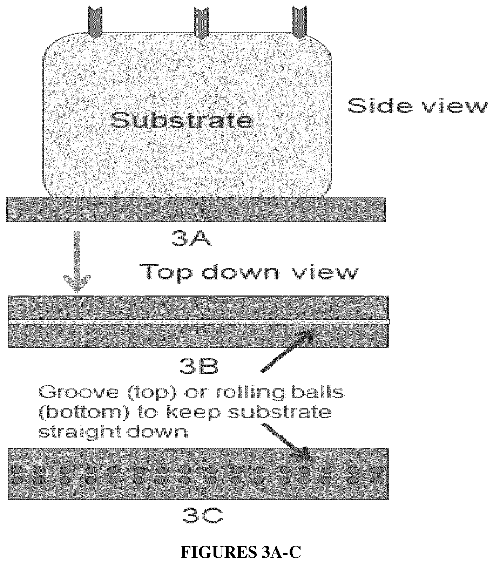

The securing means for the thin film substrates can also be a conveyor which has a groove for securing one end of the thin film or it can be a plurality of pairs of rolling balls as shown in Figures 3A-C. The bottom end of the thin film substrate may rest secured in the groove of the conveyor with a plurality of electrical connectors joined to the opposite end of the thin film as shown in Figure 3A and 3B. The groove is sufficiently wide enough to accept the bottom end of the thin film and at the same time secure it such that is does not move laterally from its position in the groove. The electrical connectors can also be joined to the thin film as one or both of the two sides instead of at the top. Alternatively, the thin film may be secured by the conveyor with the groove at its top with the electrical connectors at the bottom or sides (not shown). As described above, the conveyor drives the thin films to a plating tank and when the thin films enter the plating tank the connectors make contact at their opposite ends to an electric rail by means of a gliding contact. The thin films then pass through the plating tank in one plane where they are copper plated and then pass out at the opposite end where they are retrieved.

Alternatively, the conveyor has a plurality of pairs of rolling balls as shown in Figure 3C. The thin film is secured between the rolling balls in a similar fashion as with the conveyor with the groove except the balls are motorized such that they rotate and drive the thin film forward toward and into the plating tank while maintaining the thin film in one pale such that it does not move laterally during electroplating.

Copper metal is electroplated from low stress, high ductility aqueous acid copper electroplating baths. Preferably such aqueous acid copper metal electroplating baths include one or more sources of copper ions, an electrolyte, one or more branched polyalkylenimines, one or more accelerators and one or more suppressors such that the copper deposits have low internal stress and high ductility, preferably minimal change in stress as the copper deposit ages and high ductility. The low internal stress copper deposits may have a matt appearance with a relatively large as deposited grain size, typically of 2 microns or more. The acid, low stress, high ductility copper baths also may include one or more sources of chloride ions and one or more conventional additives typically included in acid copper electroplating baths. Preferably, one or more sources of chloride ions are included in the acid copper electroplating baths.

The one or more branched polyalkylenimines include, but are not limited to compounds having a general formula: 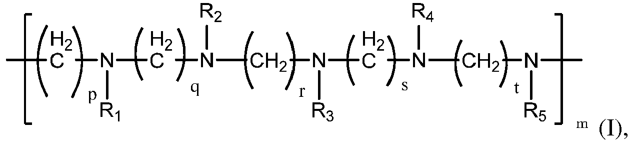 where R₁, R₂, R₃, R₄ and R₅ may be hydrogen or a moiety having a general formula: 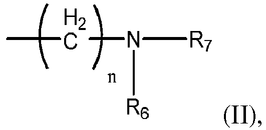 where R₆ and R₇ are the same or different and are hydrogen or a moiety having a general formula: 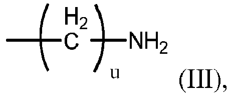 with the proviso that at least one of R₁, R₂, R₃, R₄ and R₅ is the moiety having formula (II) and n, p, q, r, s, t and u are the same or different and are integers of 2 to 6 and m is an integer of 2 or greater. Preferably, at least two of R₁, R₂, R₃, R₄ and R₅ are the moiety having formula (II), more preferably three of R₁, R₂, R₃, R₄ and R₅ are the moiety having formula (II). Preferably, at least one of R₆ and R₇ is the moiety having formula (III) with the remainder being hydrogen. Preferably, the variables n, p, q, r, s, t and u are the same or different and are 2 to 3, more preferably, n, p, q, r, s, t and u are 2.

Examples of preferred branched polyalkylenimines are the following polyethylenimines: 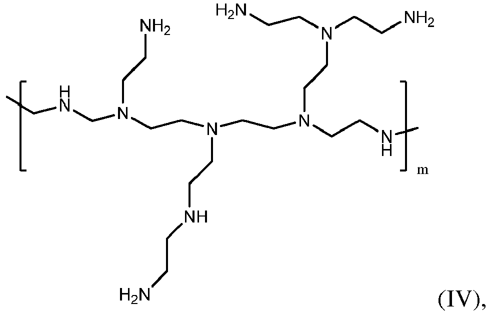 and 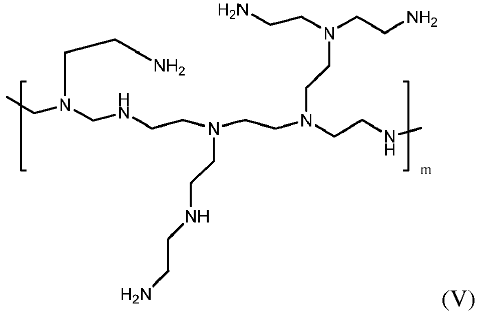 where the variable m is as defined above.

An example of another branched polyalkylenimine is the dendrimer having the following structure:

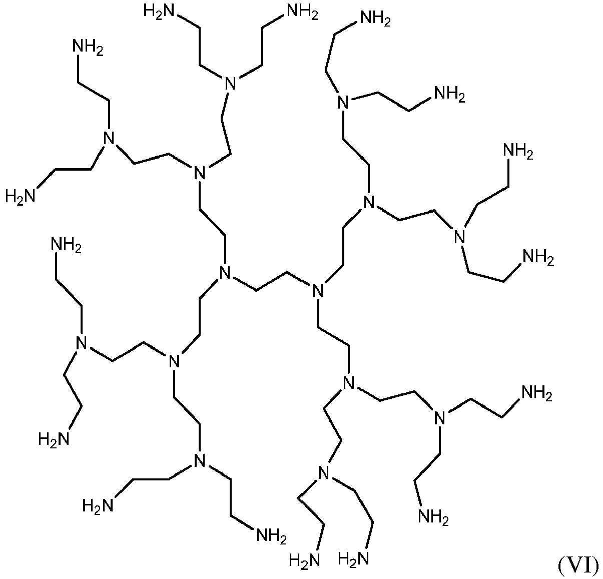

The branched polyalkylenimines are included in the acid copper electroplating baths in amounts of 0.1 to 10 ppm, preferably from 0.1 to 5 ppm, more preferably from 0.1 to 2 ppm and most preferably 0.1 to 1 ppm. The preferred and the most preferred branched polyalkylenimines may be included in the low stress, high ductility acid copper electroplating baths in amounts of 0.2 ppm to 0.8 ppm.

In general Mw may range from 1000 and greater. Typically the Mw may range from 4000 to 60,000, more typically from 10,000 to 30,000.

Preferred low internal stress, high ductility copper electroplating baths can also include one or more polyallylamines which have a general formula: 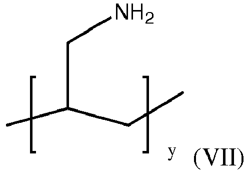 where variable "y" is a number such that the Mw is 1000 g/mole or greater. Preferably the Mw of the polyallylamines of the present invention ranges from 4000 g/mole to 60,000 g/mole, more preferably from 10,000 g/mole to 30,000 g/mole.

Polyallylamines are included in the aqueous acid copper electroplating baths in amounts of 1 to 10 ppm, preferably from 1 to 5 ppm, more preferably from 1 to 2 ppm.

One or more accelerators are included in the low stress and high ductility acid copper electroplating baths. Accelerators are preferably compounds which in combination with one or more suppressors may lead to an increase in plating rate at given plating potentials. The accelerators are preferably sulfur containing organic compounds. Preferably the accelerators are 3-mercapto-1-propane sulfonic acid, ethylenedithiodipropyl sulfonic acid, bis-(ω-sulfobutyl)-disulfide, methyl-(ω-sulfopropyl)-disulfide, N,N-dimethyldithiocarbamic acid (3-sulfopropyl) ester, (O-ethyldithiocarbonato)-S-(3-sulfopropyl)-ester, 3-[(amino-iminomethyl)-thiol]-1-propanesulfonic acid, 3-(2-benzylthiazolylthio)-1-propanesulfonic acid, bis-(sulfopropyl)-disulfide and alkali metal salts thereof. More preferably, the accelerator is chosen from 3-mercapto-1-propane sulfonic acid and its alkali metal salts and (O-ethyldithiocarbonato)-S-(3-sulfopropyl)-ester and its alkali metal salts. Most preferably, the accelerator is chosen from 3-mercapto-1-propane sulfonic acid, sodium salt and (O-ethyldithiocarbonato)-S-(3-sulfopropyl)-ester, potassium salt. While not being bound by theory, it is believed that the one or more accelerators in combination with the one or more branched polyalkylenimines or polyallylamines enable the combination of a low internal stress and high ductility copper metal film deposit.

In general, such accelerators may be included in amounts of 1ppm and greater. Preferably such accelerators may be included in the acid copper electroplating baths in amounts of 2 ppm to 500 ppm, more preferably from 2 ppm to 250 ppm, most preferably the accelerators are included in amounts of 3 ppm to 200 ppm. When the accelerators are chosen from 3-mercapto-1-propane sulfonic acid and its alkali metal salts they are most preferably included in amounts of 3 ppm to 8 ppm, and (O-ethyldithiocarbonato)-S-(3-sulfopropyl)-ester and its alkali metal salts are most preferably included in amounts of 100 ppm to 200 ppm.

Suppressors included in the low stress, high ductility acid copper electroplating baths include, but are not limited to, polyoxyalkylene glycols, carboxymethylcellulose, nonylphenolpolyglycol ether, octandiolbis-(polyalkylene glycolether), octanolpolyalkylene glycol ethers, oleic acidpolyglycol ester, polyethylenepropylene glycol, polyethylene glycol, polyethylene glycoldimethylether, polyoxypropylene glycol, polypropylene glycol, polyvinylalcohol, stearic acid polyglycol ester and stearyl alcohol polyglycol ether. Such suppressors are included in amounts of 0.1 g/L to 10 g/L, preferably from 0.1 g/L to 5 g/L, more preferably from 0.1 g/L to 2 g/L and most preferably from 0.1 g/L to 1.5 g/L.

Suitable copper ion sources are copper salts and include without limitation: copper sulfate; copper halides such as copper chloride; copper acetate; copper nitrate; copper tetrafluoroborate; copper alkylsulfonates; copper aryl sulfonates; copper sulfamate; copper perchlorate and copper gluconate. Exemplary copper alkane sulfonates include copper (C₁-C₆)alkane sulfonate and more preferably copper (C₁-C₃)alkane sulfonate. Preferred copper alkane sulfonates are copper methanesulfonate, copper ethanesulfonate and copper propanesulfonate. Exemplary copper arylsulfonates include, without limitation, copper benzenesulfonate and copper p-toluenesulfonate. Mixtures of copper ion sources may be used. One or more salts of metal ions other than copper ions may be added to the acid copper electroplating baths. Typically, the copper salt is present in an amount sufficient to provide an amount of copper ions of 10 to 400 g/L of plating solution. The electroplating baths do not include any alloying metals. The electroplating baths are directed to thin film copper deposits, not copper alloy deposits or any other metal or metal alloy.

Suitable electrolytes include, but are not limited to, sulfuric acid, acetic acid, fluoroboric acid, alkanesulfonic acids such as methanesulfonic acid, ethanesulfonic acid, propanesulfonic acid and trifluoromethane sulfonic acid, aryl sulfonic acids such as benzenesulfonic acid, p-toluenesulfonic acid, sulfamic acid, hydrochloric acid, hydrobromic acid, perchloric acid, nitric acid, chromic acid and phosphoric acid. Mixtures of acids may be used in the present metal plating baths. Preferred acids include sulfuric acid, methanesulfonic acid, ethanesulfonic acid, propanesulfonic acid, hydrochloric acid and mixtures thereof. The acids may be present in an amount in the range of 1 to 400 g/L. Electrolytes are generally commercially available from a variety of sources and may be used without further purification.

One or more optional additives may also be included in the electroplating composition. Such additives include, but are not limited to, levelers, surfactants, buffering agents, pH adjustors, sources of halide ions, organic acids, chelating agents and complexing agents. Such additives are well known in the art and may be used in conventional amounts.

Levelers may be included in the acid copper electroplating bath. Such levelers include, but are not limited to, organic sulfo sulfonates such as 1-(2-hydroxyethyl)-2-imidazolidinethione (HIT), 1-mercaptopyridine, 2-mercaptothiazoline, ethylene thiourea, thiourea, those disclosed in U.S. Pat. Nos. 6,610,192 to Step et al., 7,128,822 to Wang et al., 7,374,652 to Hayashi et al. and 6,800,188 to Hagiwara et al. Such levelers may be included in conventional amounts. Typically they are included in amounts of 1ppb to 1 g/L.

Conventional nonionic, anionic, cationic and amphoteric surfactants may be included in the acid copper electroplating baths. Such surfactants are well known in the art and many are commercially available. Typically the surfactants are nonionic. In general, surfactants are included in conventional amounts. Typically they may be included in the electroplating baths in amounts of 0.05 g/l to 15 g/L.

Halogen ions include chloride, fluoride, and bromide. Such halides are typically added into the bath as a water soluble salt or acid. Preferably, the copper electroplating baths include chloride. Chloride is preferably introduced into the bath as hydrochloric acid or as sodium chloride or potassium chloride. Preferably chloride is added to the bath as hydrochloric acid. Halogens may be included in the baths in amounts of 20 ppm to 500 ppm, preferably 20 ppm to 100 ppm.

The low stress, high ductility acid copper electroplating baths have a pH range less than 1 to less than 7, preferably from less than 1 to 5, more preferably from less than 1 to 2, most preferably the pH is less than 1 to 1.

Electroplating may be by DC plating, pulse plating, pulse reverse plating, light induced plating (LIP) or light assisted plating. Preferably the low stress, high ductility copper films are plated by DC, LIP or light assisted plating. In general, current density ranges from 0.5-50 ASD depending on the application. Typically, the current density ranges from 1-20 ASD or such as 15-20 ASD. Electroplating is done at temperature ranges from 15 °C to 80 °C or such as from room temperature to 60 °C or such as from 20 °C to 40 °C or such as from 20 °C to 25 °C.

The internal stress and ductility of the copper films may be determined using conventional methods. Typically low internal stress is measured using a deposit stress analyzer, such as is available from Specialty Testing and Development Co., Jacobus, PA. The low internal stress may be determined by the equation S=U/3TxK, where S is stress in psi, U is number of increments of deflection on a calibrated scale, T is deposit thickness in inches and K is the test strip calibration constant. The constant may vary and is provided with the deposit stress analyzer. Low internal stress is measured immediately after plating and then after ageing for a few days, preferably two days after the copper film is deposited on a substrate, such as a conventional copper/beryllium alloy test strip. Internal stress measurements immediately after electroplating and after ageing are made at room temperature. While room temperature may vary, for purposes of measuring internal stress, room temperature typically ranges from 18 °C to 25 °C, preferably from 20 °C to 25 °C. Preferably, a copper film of 1-10 µm is plated on the test strip, more preferably 1-5 µm. Initial internal stress which is measured immediately after plating copper on the substrate may range from 0 psi to 950 psi, preferably from 0 psi to 520 psi, more preferably from 0 psi to 505 psi at room temperature. After ageing, such as for two days, the internal stress may range from 300 psi to 900 psi, preferably from 300 psi to 850 psi, more preferably from 300 psi to 800 psi at room temperature. While internal stress may vary slightly from the two days ageing time period, the measurement of the internal stress of a copper film typically does not significantly change at room temperature after the two day ageing period.

Ductility is measured using conventional elongation tests and apparatus. Preferably, elongation testing is done using industrial standard IPC-TM-650 methods with an apparatus such as an Instron pull tester 33R4464. Copper is electroplated on a substrate such as a stainless steel panel. Typically copper is electroplated as a thin film on the substrate to a thickness of 50-100 µm, preferably from 60-80 µm. The copper is peeled from the substrate and annealed for 1- 5 hours, preferably from 2-5 hours. Annealing is done at temperatures of 100-150 °C, preferably from 110-130 °C, and then the copper is allowed to come to room temperature. Elongation or load of maximum tensile stress is typically not a pre-set parameter. The greater the load of maximum tensile stress a material can withstand before failing or cracking, the higher or the better the ductility. Typically elongation is done at loads of maximum tensile stress of 50 lbf or greater. Preferably, elongation is done at 60 lbf or greater. More preferably elongation is done at loads of maximum tensile stress of 70 lbf to 90 lbf. Elongation ranges from greater than or equal to 8%, preferably from 9% to 15%.

The methods of the present invention are used to plate copper on thin film substrates such as semiconductor wafers or metal thin films, or on sides of substrates where bowing, curling or warping are problems. The methods can also be used to plate copper on difficult to adhere to substrates where blistering, peeling or cracking of the deposit are common. For example, the methods may be used in the manufacture of printed circuit and wiring boards, such as flexible circuit boards, flexible circuit antennas, RFID tags, electrolytic foil, semiconductor wafers for photovoltaic devices and solar cells, including interdigitated rear contact solar cells, heterojunction with intrinsic thin layer (HIT) cells and fully plated front contact cells. The methods are used to preferably plate copper at thickness ranges of 15µm to 5mm, more preferably from 20µm to 1mm. When copper is used as the principle conductor in the formation of contacts for solar cells, the copper is preferably plated to thickness ranges of 20µm to 60µm, more preferably from 30µm to 50µm.

The following examples are provided to illustrate the invention, but are not intended to limit its scope.

### Example 1

The following aqueous acid copper electroplating baths are prepared at room temperature.

**Table 1**

| Component | Bath 1 | Bath2 |
|---|---|---|
| Copper sulfate | 160 g/L | 160 g/L |
| Sulfuric acid | 150 g/L | 150 g/L |
| Chloride (as hydrochloric acid) | 60 ppm | 60 ppm |
| Bis-sodium sulfopropyl-disulfide | 4 ppm | 0 |
| 3-mercapto-1-propane sulfonic acid, sodium salt | 6 ppm | 0 |
| (O-ethyldithiocarbonato)-S-(3-sulfopropyl)-ester, potassium salt | 0 | 150 ppm |
| Polyoxy-alkylene glycol | 0.15 g/L | 0.9 g/L |
| Polyethylene glycol | 0.18 g/L | 1.1 g/L |
| Branched polyethylenimine (Mw = 25000) | 0.75 ppm | 0.75 ppm |

The components of the copper electroplating baths are made up using conventional laboratory procedures where organics are added to water followed by adding the inorganic components. Stirring or agitation with heat application at temperatures of below 30 °C is done to be certain that all of the components are solubilized in the water. The baths are allowed to come to room temperature prior to copper electroplating. The pH of the acid copper electroplating baths ranges from less than 1 to 1 at room temperature and during copper electroplating.

### Example 2

A plurality of thin films of copper having thicknesses of 100 µm are joined to non-conducting rectangular flat panel plating jigs as illustrated in Figure 2A. Each thin film is secured to a flat panel plating jig by six electrical contacts, three on each side of the thin film or in the alternative by three electrical contacts and three non-electrical contacts as shown in Figures 2A and 2B. The non-conducting flat panel plating jigs with the thin films are secured to a conveyor system where the plating jig is joined to the conveyor such that it does not move outside a single plane and which transports the thin films through plating tanks which contain Bath 1 or Bath 2 as in Example 1. The thin films remain substantially in one plane during the electroplating process. When the thin copper films joined to the flat panel jigs pass into one of the two copper plating baths, the electrical contacts are placed under a potential from an electric rail which makes electrical contact with the contacts joining the thin films of copper. Each panel is electroplated with a layer of copper 30 µm thick. Copper electroplating is initiated at 1.5 ASD to 3 ASD to plate an initial 0.1-4 µm of copper then the current density is increased to 20ASD to complete the plating. Plating is DC and at room temperature. After the thin films are plated with copper they pass out of the copper plating tanks, they are rinsed with DI water and examined for any warping. None of the thin films show observable signs of warping immediately after plating. The samples are then allowed to age at room temperature for about 24 hours. After 24 hours the samples are observed for warping. There are no observable signs of substrate or copper layer warping.

### Example 3

The following aqueous acid copper electroplating baths are prepared at room temperature.

**Table 2**

| Component | Bath 3 |
|---|---|
| Copper sulfate | 160 g/L |
| Sulfuric acid | 150 g/L |
| Chloride (as hydrochloric acid) | 60 ppm |
| (O-ethyldithiocarbonato)-S-(3-sulfopropyl)-ester, potassium salt | 175 ppm |
| Polyoxy-alkylene glycol (PolyMax™ PA-66/LC solution) | 0.15 g/L |
| Polyethylene glycol (PEG 12000) | 0.18 g/L |
| Polyallylamine (Mw = 15000) | 1.25 ppm |

The components of the copper electroplating bath are made up using conventional laboratory procedures where organics are added to water followed by adding the inorganic components. Stirring or agitation with heat application at temperatures of below 30 °C is done to be certain that all of the components are solubilized in the water. The bath is allowed to come to room temperature prior to copper electroplating. The pH of the acid copper electroplating bath is less than 1 at room temperature and during copper electroplating.

### Example 4

A plurality of thin films of copper having thicknesses of 150 µm are connected to three electrical contacts and inserted in a conveyor with grooves or alternatively a conveyor with rollers as illustrated in Figures 3A-C. The groove and rollers secure the thin films such that they remain in one plane during transport to and during passage through low internal stress, high ductility copper electroplating baths. Two plating tanks include the low internal stress, high ductility copper electroplating baths as shown in Example 3. When the thin copper films pass into one of the two copper plating baths, the electrical contacts are placed under a potential from an electric rail which makes electrical contact with the contacts joining the thin films of copper. Each panel is electroplated with a layer of copper 30 µm thick. Electroplating is done at room temperature. The current density is at 20 ASD using DC. After the thin films are plated with copper they pass out of the copper plating tanks, they are rinsed with tap water and examined for any warping. None of the thin films show observable signs of warping. The samples are then allowed to age at room temperature for 24 hours. After 24 hours, the samples are observed for warping. No warping was observed for any of the samples.

### Example 5 (comparative)

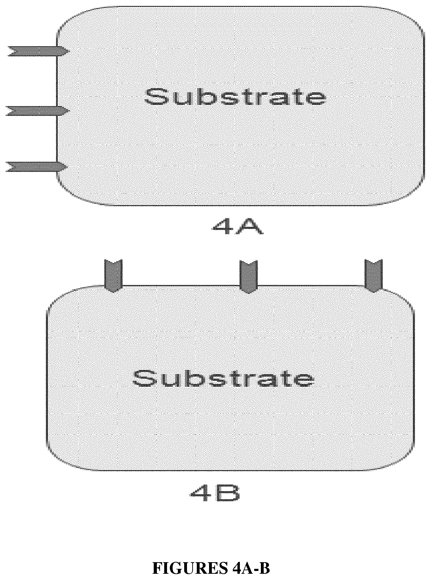

A plurality of thin films of copper having thicknesses of 120 µm are connected to three electrical connectors on one side or at the top as shown in Figures 4A and 4B. The connectors are joined to a conveyor which transports the plurality of thin films to a copper plating tank which includes one of the low internal stress, high ductility copper electroplating baths shown in tables 1 and 2 above. The thin films are secured to the conveyor only by means of the electrical connectors. When the thin copper films pass into one of the three copper plating baths, the electrical contacts are placed under a potential from an electric rail which makes electrical contact with the contacts joining the thin films of copper. Each panel is electroplated with a layer of copper 30 µm thick at a current density of 20ASD with DC. Electroplating is done at room temperature. During passage through the electroplating baths the thin films change their planar orientation due to contact with the aqueous plating baths as well as due to the continuous stirring of the baths during electroplating. The thin films are not copper plated in a single continuous plane as in Examples 2 and 4. After the thin films are plated with copper they pass out of the copper plating tanks, they are rinsed with tap water and examined for any warping. All of the samples had some observable signs of warping. The samples are then aged at room temperature for 24 hours. After 24 hours, the warping of all of the samples is more pronounced. The plated copper layers for most of the samples show signs of peeling from the thin film substrate. All of the substrates have bowing.

## Claims

1. A method of copper electroplating a thin film substrate comprising:
a) providing the thin film substrate;
b) attaching the thin film substrate to a securing means to inhibit substantially all motion of the thin film substrate in relation to the securing means;
c) attaching one or more electrical contacts to the thin film substrate;
d) passing the thin film substrate attached to the securing means and with the one or more electrical contacts through a low stress, high ductility acid copper electroplating bath wherein the thin film substrate and securing means with the one or more electrical contacts remain substantially in a single plane while passing through the copper electroplating bath; and
e) electroplating low stress, high ductility copper on the thin film substrate with the low stress, high ductility copper electroplating bath.

2. The method of claim 1, wherein the thin film substrate is 220 µm thick or less but greater than 0.

3. The method of claim 1, wherein the thin film substrate attached to the securing means is passed through the low stress, high ductility copper electroplating bath by a conveyor.

4. The method of claim 3, wherein the securing means is a plating jig joined to the conveyor.

5. The method of claim 1, wherein the securing means is a conveyor comprising a groove for securing the thin film substrate during electroplating.

6. The method of claim 1, wherein the securing means is a conveyor comprising a plurality of pairs of rolling balls securing the thin film substrate during electroplating.

7. The method of claim 1, wherein the low internal stress, high ductility acid copper electroplating bath comprises one or more sources of copper ions, an electrolyte, one or more branched polyalkylenimines, one or more accelerators and one or more suppressors.

8. The method of claim 1, wherein the low internal stress, high ductile acid copper electroplating bath comprises one or more sources of copper ions, an electrolyte, one or more polyallylamines, one or more accelerators and one or more suppressors.
